# EUROPEAN PATENT APPLICATION

(11) **EP 2 886 205 A1**
(43) Date of publication of application: **24.06.2015**
(21) Application number: 13198629.1
(22) Date of filing: 19.12.2013
(51) Int. Cl.: B05D 5/08, G02B 1/11, C23C 14/34, C03C 17/00, C23C 14/56, C23C 16/455

(54) **Method for antireflective coating protection with organosilanes**

(71) Applicant: Institute of Solid State Physics, University of Latvia, 1063 Riga (LV)
(72) Inventor: Kundzins, Karlis, 1010 Riga (LV)
(74) Representative: Zaboliene, Reda

(57) **Abstract**

Disclosed is a method for forming a protective antireflective and hydrophobic coating film, which enables to form a transparent protective coating film having excellent coating film properties such as fouling, the durability, and the transparency is not sticky, and stable for long time storage. A main object of the present invention is achieved by no exposition of glass to the atmosphere after magnetron deposition and before silanization process.

## Description

### FIELD OF THE INVENTION

The present invention relates to a method of making antireflective hydrophobic glass. This method is related to a hydrophobic and/or oleophobic coating on magnetron sputtered microstructured glass surfaces providing an hydrophobic and/or oleophobic effect.

### BACKGROUND OF THE INVENTION

A variety of coatings has been taught in the prior art for the purpose to either provide hydrophobic coatings on glass.
It has lately been desired to provide a coating composition for forming a coating which is improved in the resistance to climate, the resistance to fouling, and the resistance to chemicals while being high in the physical hardness. It is also anticipated that such compositions should be arranged favorable for common use. Organosilane coating materials have technically been developed for use as maintenance-free coating materials which are advantageous for the resistance to climate (and sunlight), fouling, and so forth. The demand for improving the performance of organosilane coating materials is overwhelmingly increased. Therefore, it is now desired to provide coating materials which are improved in the coating appearance, the adhesively, the resistance to climate, heat, alkalis, organic chemicals, moisture, and (hot) water, the insulating property, the abrasion resistance, the resistance to fouling, and so forth and are thus capable of forming a coating of a higher hardness.
US2009/0202817 discloses a method for synthesizing a hydrophobic/oleophobic coating on a glass, ceramic or glass-ceramic substrate, preferably glass substrate, by bringing said substrate into contact with a mixture of an excited gas originating from a device generating an atmospheric pressure plasma and of a gas containing at least one fluoro compound, said method being characterized in that a sublayer, the thickness of which is between 1 and 100 nm, is first deposited on said substrate. It also relates to a product, comprising monolithic, laminated or multiple glazing, equipped on at least one part of at least one of its surfaces with a hydrophobic/oleophobic coating obtained by the implementation of the method.
In US20090326146 a process to produce silane coating is described, wherein one or several silanes, which are not or only minimally pre-condensed, are charged with a reactant and the thus created coating material is applied onto a substrate and then hardened. The reaction involves higher-molecular and only slightly pre-cross-linked silanes with a suitable reactant. Silanes are processed in sol-gel processes, where pre-condensated species are assumed.
WO9919084A1 describes a water based coating material with alcohol as a solvent, fluorinated silanes and an acid to provide a hydrophobic coating on glass. EP0799873B1 is concerned with a coating material comprising water, an alcohol, fluorinated silanes and an acid to provide a hydrophobic coating on glass. US6340502B1 describes a coating material comprising a fluorinated alkoxysilane and a fluorinated halosilane for obtaining a hydrophobic coating.
All mentioned patent documents have disadvantage that coating process is effected in liquid and silanisation performs always after exposition in air. Usually glass before the treatment with the silanes is exposed to the air and then is washed with an acid and rinsing with water.

### BRIEF SUMMARY OF THE INVENTION

In order to overcome the problems above it is an aspect of the present invention to provide an organosilanes-based antireflective coating.
The present invention has been invented in view of overcoming the foregoing technical drawbacks of the prior arts and its object is to provide a method of making antireflective hydrophobic coating layers to provide a coating glass which is improved in the resistance to fouling, the durability, and the transparency and has a hydrophobic function while the coating is easily applied on a glass substrate, and provide antireflective glass produced by the method.
The hydrophobic glass according to the present invention is produced by providing coating layers on the surface of a glass with the use of a method of making hydrophobic coating layers defined below.

### BRIEF DESCRIPTION OF THE DRAWINGS

Fig.1 Antireflective glass
   1- Substrate (glass, soda-lime glass)
   2- TiO₂ layer
   3- SiO₂ layer
   4- TiO₂ layer
   5- SiO₂ layer
   6- organosilane monolayer
Fig. 2 Sputtering-coating device
   1- vacuum chamber
   2- 2A, 2B, 2C air lock
   3- magnetron sputtering targets
   4A- glass sheet during magnetron sputtering
   4B- antireflective glass sheet during silanisation process
   5- vacuum pumps
   6- gas injection system
   7- container with organosilanes
   8- temperature regulation system
   9- buffer gas
   10- sputtering equipment (electric power supplier, gas injection systems, mechanical translators etc.)
   11- tube

### DETAILED DESCRIPTION OF THE INVENTION

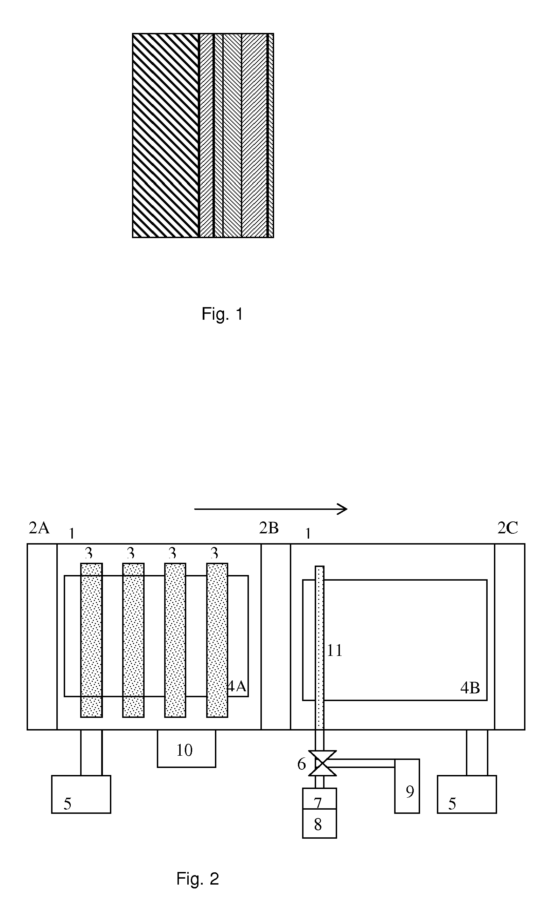

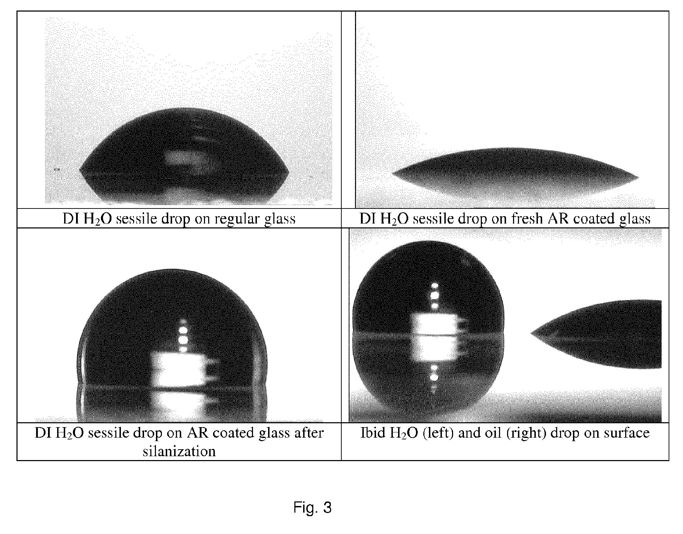

At the first stage the glass with thickness 3-8 mm is pre-washed in horizontal position, and flushed with filtered water. After that the glass is polished with CeO emulsion in DI water by rinsing several times with heated DI water at 30-70°C. At the end of this stage water is removed with compressed air.
At the second stage the glass sheet 4A is turned vertically and is set in metal translation frame. There are used 10 vacuum vertical sluice chambers (1) which are provided with 2-8 vacuum turbomolecular pumps (5). Said metal translation frame is dragged through vacuum chambers by chains with a speed from 0,5 till 2 m/min., preferably 1 m/min.
At the beginning of this stage optionally an oxygen plasma cleaning is used in order to remove of impurities and contaminants from surfaces of the glass. Such foreign contaminants can severely degrade the optical performance of such coatings by altering the path of impinging light.
The vacuum chambers (1) are supplied with up to 8 rotating cylindrical magnetron targets (3) about 10-50 kW each and working voltage AC 300-500V. The target has diameter 20 cm, and is in distance of 5-10 cm from glass. The targets are coated with different substances: SiO₂ target is Si with 10 wt % Al, TiOₓ target with value of 1,76 ± 0,05, targets with zinc (Zn), indium (In), nickel (Ni), aluminium (Al). These said targets are working in dual magnetron sputtering mode with power 5-20 kW/m. The mixture of argon (Ar) and reactive O₂ gas flow for sputtering is supplied at a pressure about 0,1-1 Pa. The ratio of Ar with O₂ is from 1:10 till 10:1, preferably 1:1. The gas is passed through mass-flow controllers and is distributed uniformly through gas showers near targets. The gas is supplied initially at room temperature and growing up to 80°C. Magnetron deposition in oxygen gas/Ar buffer gas is effected in vacuum at pressure 0.1-10 mbar. Immediately after magnetron sputtering glass sheet (4A) through air-lock goes to the silanization step.
A main object of the present invention is achieved by no exposition of glass to the atmosphere after magnetron deposition and before silanization process. Due to this reason the glass sheet remains especially clean, without impurities and OH groups present in the layer of the glass is not exposed to the air and have many free covalent bounds. The formation of the last layer is effected by covering with silanes (covalent bond, 1 molecular monolayer). These monolayers consist of an head group that binds to the OH- atoms on the surface and an tail that self-organizes to network of carbon chains. The layer dimensions are no more than 1-10 nm in thickness. Many OH groups on the SiO₂ surface during the formation the last layer (silanization step) have attracted Si particles and forms hydrophobic surface which has very low energy, "push" the water, and has very high glide and hydrophobic properties (Fig. 3). In closed chamber designs, substrates are supported above or adjacent to the organosilane container (7) and the container is heated to sufficient temperature using temperature regulation system (8) to achieve 0,5-200 Torr vapour pressure with or without buffer gas (9). Injection of silane vapour is effected directly by sprinkling or, preferably, by bubbling with buffer gas or, more preferably, through mass-flow controller using gas injection system (6).
The coating of 1-6 oxide layers (typical 2-4) with different refractive indexes is obtained. The said coating comprises following layers (Fig. 1) which form antireflective coating:
1^{st} 5-50 nm TiO₂ (high refraction index)
2^{nd} 10-100 nm SiO₂ (low refraction index)
3^{rd} 50-200 nm TiO₂
4^{th} 100-200 SiO₂.

The organosilanes is described by the general formula C₁₀H₂₄O₃Si, and preferably is isobutyl(trimethoxy)silae, methyl(tripropoxy)silane.

Mentioned antireflective coating finalizes with coating with low refraction index, in this case SiO₂ and the glass with mentioned antireflective coating (4B) is obtained.
The sputtering coating device (Fig. 2) is equipped with stainless steel container (7) 500 cm³ which is filled with isobutyltrimethoxysilane (Gelest Inc.). The mentioned container (7) is equipped with electric heater (8) 250 W, stabilized by thermoregulator CD701 with Pt100 sensor, which provides stable (+/-2ºC) temperature in range 50-250ºC. The mentioned container (7) is connected to the vacuum chamber with stainless steel pipe, diameter 20 mm. Vapour flow is controlled with a mass flow meter and regulated by needle valves (6) in range 3-1000 ccm (typical in this case 250 ccm)(cubic centimeter per minute). It is possible to dilute vapour concentration up to 10 times with N₂ gas with gas balloon (9). To ensure an uniform vapour distribution in vacuum chamber across the moving glass surface, parallel to the glass in 50 mm is positioned tube (10) with holes diameter 1 -5 mm every 25 mm.
The present invention is embodied and in a process for applying antireflective hydrophobic coating, wherein the coating is hydrophobic, oil-repellent, and stain-resistant. The hydrophobic coating is chemically stable, i.e., non-reactive with various solvents and detergents, and it is mechanically and environmentally stable, i.e., resistant to variations in temperature, humidity and ultraviolet light. In addition, the hydrophobic coating is uniform, with no pin-hole or spot defects, and its use is not limited to any particular substrate size. Further, the coating is environmentally friendly and does not require the need for wiping or rinsing during the application process. For the hydrophobic effect is used a polymer monolayer with sufficiently low surface energy on the substrate coating, attach to the substrate with covalent bonds.
After silanization, glass plate is removed from vacuum through air-lock 2C and optionally is cured, washed and dried.
The antireflective, hydrophobic coating of the invention is suitable for application to substrates containing metallic or inorganic components, including by way of example SiO₂, TiO₂, Al₂O₃, ZnO₂, In₂O₃, Sb₂O₃, MgF₂, and SnO₂.
The invention is further illustrated by the following process examples. It is understood that the present invention is not limited thereto.

### EXAMPLE 1

Soda-lime glass 120x160 cm, 3 mm thick, covered from both sides with 4 layer AR TiO₂/SiO₂/TiO₂/SiO₂ stack, developed for art picture framing (transmission 98% in visible range).
After last SiO₂ layer deposition with magnetrons, glass through air-lock enters to vacuum chamber with assistance of perforated tube (11) wapour of isobutyltrimethoxysilane, diluted with Ar gas in ratio 1:10, which is applied to glass surface with following parameters: distance to glass 30-50 mm, chamber pressure 1.5 mbar, wapour flow rate 200 cm³/min, Ar flow rate 2 liter/min. Process time 8-10 min, at the beginning glass temperature is 45-50ºC and drops to the 30-40ºC.
After silanization no additional curing process was applied.

### EXAMPLE 2

Soda-lime glass 120x160 cm, 3 mm thick, covered from both sides with 4 layer AR TiO₂/SiO₂/TiO₂/SiO₂ stack, developed for art picture framing (transmission 98% in visible range).
After last SiO₂ layer deposition with magnetrons, glass through air-lock enters to vacuum chamber with assistance of perforated tube (11) wapour of chlorinated polydimethylsiloxane, diluted with Ar gas in ratio 1:10, which is applied to glass surface with following parameters: distance to glass 30-50 mm, chamber pressure 1.5 mbar, wapour flow rate 50 cm³/min, Ar flow rate 500cm³/min. Process time 8-10 min, at the beginning glass temperature is 45-50ºC and drops to the 30-40ºC.
After silanization no additional curing process was applied.

The invention is further illustrated by the following product obtained by the process examples. It is understood that the present invention is not limited thereto.

### EXAMPLE 3

Soda-lime glass 3 mm, coated with antireflective coating 4 layer alternated TiO₂/SiO₂ Contact angle measurements is done to applied deionized water drops 30-50 mkl and oleic acid drops 20-50 mkl.
Sputtering conditions: U 330V, I 150 mA, growing speed 20-200 nm/min
Ar:O₂ ratio 5:2
2.5 mBar pressure

**Table No. 1**

| Sample | Contact angle, DI water, (º) | Contact angle, oleic acid, (º) | Contact angle, DI water, after 100 abrasition cycles, (º) | Contact angle, DI water, after 10 days, (º) |
|---|---|---|---|---|
| Uncoated UC1 | 10 | <3 | 12 | 12 |
| Uncoated UC2 | 12 | <3 | 12 | 20 |
| Uncoated UC3 | 15 | 5 | 14 | 22 |
| Coated CI-1 | 92 | 33 | 95 | 90 |
| Coated CI-2 | 98 | 35 | 93 | 95 |
| Coated CI-3 | 95 | 35 | 92 | 95 |

### EXAMPLE 4

Soda-lime glass 4 mm
Single layer SiO₂ from target Si with 10 wt.% of Al
SiO₂ layer thickness 120 nm
Deionized water drops 30-50 mkl
Oleic acid drops 20mkl

**Table No. 2**

| Sample | Contact angle, DI water, (º) | Contact angle, oleic acid, (º) | Contact angle, DI water, after 12 h 60ºC |
|---|---|---|---|
| Uncoated SAO1 | 25 | 7 | 30 |
| Uncoated SAO2 | 20 | 5 | 22 |
| Coated SAOC3 | 95 | 30 | 95 |
| Coated SAOC4 | 98 | 30 | 95 |

## Claims

**1.** A process for obtaining a hydrophobic coating on a substrate, comprising:
(i) providing a first step of magnetron sputtering thus obtaining antireflective glass with four coating layers;
(ii) providing a second step of silanization in vacuum using organosilane vapour;
(iii) optionally curing, washing and drying of coated substrate.

**2.** A process for obtaining an antireflective coating on a substrate as described in claim 1, wherein the ratio of Ar with O₂ is from 1:10 till 10:1, preferably 1:1.

**3.** A process for obtaining a hydrophobic coating on a substrate as defined in claim 1 or 2, wherein immediately after magnetron deposition in the same or next chamber the glass is treated with silanes without being exposed to the air.

**4.** A process for obtaining a hydrophobic coating on a substrate as defined in any one of claim 1-3, wherein silane vapour in vacuum or in low pressure buffer gas is used in silanization step.

**5.** A process for obtaining a hydrophobic coating on a substrate as described in claim 4, wherein injection of silane vapour is effected directly by sprinkling or, preferably, by bubbling with buffer gas or, more preferably, through mass-flow controller using gas injection system.

**6.** A process for obtaining a hydrophobic coating on a substrate as described in any one of claim 1-5, wherein to ensure an uniform wapour distribution in vacuum chamber across the moving glass surface, paralel to the glass in 50 mm is positioned tube (11) with holes diameter 1 -5 mm every 25 mm.

**7.** A process for obtaining a hydrophobic coating on a substrate as described in any one of claim 1-6, wherein the layer dimensions are no more than 1-10 nm in thickness.

**7.** A process for obtaining a hydrophobic coating on a substrate as described in any one of claim 1-6, wherein organosilanes used in the silanization process preferably is isobutyl(trimethoxy)silane, methyl(tripropoxy)silane.

**8.** A process for obtaining a hydrophobic coating on a substrate as described in any one of claim 1-7, wherein for the hydrophobic effect monolayer is used with sufficiently low surface energy on the substrate coating, attach to the substrate with covalent bonds.
